# EUROPEAN PATENT SPECIFICATION

(11) **EP 3 253 187 B1**
(45) Date of publication and mention of the grant of the patent: **03.03.2021**
(21) Application number: 17151080.3
(22) Date of filing: 11.01.2017
(51) Int. Cl.: H05K 5/00

(54) **ELECTRONIC DEVICE HOUSING AND DISASSEMBLY FIXTURE THEREOF**
GEHÄUSE FÜR ELEKTRONISCHE VORRICHTUNG UND DEMONTAGEHALTERUNG DAFÜR
BOÎTIER DE DISPOSITIF ÉLECTRONIQUE ET SON DISPOSITIF DE DÉMONTAGE

(30) Priority: 04.06.2016 TW 105208464 U
(43) Date of publication of application: 06.12.2017
(73) Proprietor: Arcadyan Technology Corporation, Hsinchu City 300 (TW)
(72) Inventor: Chen, Sheng-Chung, 31055 Zhudong Township, Hsinchu County (TW); Lian, Tai-Tong, 350 Zhunan Township, Miaoli County (TW)
(74) Representative: Lermer, Christoph

(56) References cited:
- WO-A1-2014/012396
- DE-A1- 19 642 517
- US-A1- 2014 016 996

## Description

### TECHNICAL FIELD

The present invention relates to an electronic device housing, in particular to an electronic device housing easily to be disassembled. The present invention further relates to a disassembly fixture for disassembling the electronic device housing.

### BACKGROUND

Generally speaking, if a repair technician needs to check and repair an electronic device, the repair technician should use a disassembly fixture to disassemble the housing of the electronic device before checking and repairing the circuit board and other electronic components of the electronic device.

However, the housing of the electronic device usually has a front cover and back cover fixed with each other by several screws; therefore, the repair technician should loosen and remove these screws before disassembling the housing of the electronic device. Thus, if the repair technician needs to deal with a lot of electronic devices, the repair technician should loosen and remove the screws of all of these electronic devices one by one, which is extremely inefficient.

In addition, the repair technician should further align the performed holes of the back cover with a specially-designed fixture so as to insert the fixture into the performed holes to fix the back cover, and the use both of his hands to remove the front cover, which is very inconvenient in use; besides, the surface of the front cover tends to be scraped or even broken.

The WO 2014/012396 A1 describes a method and apparatus for disassembling a set top box. The method includes providing the set top box including a top cover, a base, and cover retention clips for securing the top cover to the base.

Therefore, it has become an important issue to provide an electronic device housing and a disassembly fixture thereof so as to improve the shortcomings of conventional electronic device housings and disassembly fixtures.

### SUMMARY

The present invention is related to an electronic device housing.

The main embodiment is defined by the independent claim; further embodiments are defined by the dependent claims. Embodiments that do not fall within the scope of the attached set of claims, do not describe the invention. In one embodiment of the present invention, the electronic device housing may include a front cover and a back cover. The front cover may include at least two flexible hooks and at least one fixation hook, and each flexible hook may include a hook body and a flexible member; one end of the flexible member may be connected to the front cover and the other end thereof may provide support force to one side of the hook body. The back cover may include at least two first fasteners, at least one second fastener and at least three holes; the holes may be corresponding to the first and the second fasteners; the first fasteners may be corresponding to the flexible hooks and caught on the flexible hooks; the second fastener may be corresponding to the fixation hook and caught on the fixation hook, whereby the front cover can be combined with the back cover.

In a preferred embodiment, the flexible hooks may be symmetrically distributed.

In a preferred embodiment, one end of the hook body may be fixed at the front cover, and the first fastener may be caught on the other end of the hook body.

In a preferred embodiment, the hook body may gradually taper and then gradually widen from one end to the other end thereof.

In a preferred embodiment, the flexible member may be a spring; one end of the spring may be fixed at the front cover and the other end of the spring may be fixed at one side of the hook body.

In a preferred embodiment, the flexible member may be an elastic arm; one end of the elastic arm may be fixed at the front cover, and the other end of the elastic arm may press against one side of the hook body.

In a preferred embodiment, one end of the fixation hook may be fixed at the front cover, and the other end of the fixation hook may include a slope and be caught on the second fastener.

In a preferred embodiment, the holes may be ventilation holes, and each of the holes may partially overlap the first fastener or the second fastener corresponding to the hole in the vertical direction.

In a preferred embodiment, the elastic arm may be curved.

In a preferred embodiment, one side of the hook body may include a protrusion, and the protrusion may press against the other end of the elastic arm.

The present invention is further related to a disassembly fixture for disassembling an electronic device housing. In one embodiment of the present invention, the disassembly fixture may include a base, at least two first disassembly pins and at least one second disassembly pin. The first disassembly pins may be disposed on the base, and respectively corresponding to the flexible hooks and the first fasteners. The second disassembly pins may be disposed on the base, and respectively corresponding to the fixation hooks and the second fasteners.

In a preferred embodiment, each of the first disassembly pins may include a pin base and a pin body, and the pin body may gradually taper from one end to the other end thereof.

In a preferred embodiment, each of the second disassembly pins may include a pin base and a pin body, and the pin body may gradually taper from one end to the other end thereof.

In a preferred embodiment, the disassembly fixture may further include a plurality of dowel pins, and the dowel pins may be disposed on the base so as to fix the electronic device housing.

In a preferred embodiment, one end of each of the dowel pins may be fixed on the base, and the other end thereof may include a slope.

The present invention is still further related to a disassembly fixture for disassembling an electronic device housing. In one embodiment of the present invention, the disassembly fixture may include a base, a plurality of dowel pins, at least two first disassembly pins and at least one second disassembly pin. The dowel pins may be disposed on the base so as to fix the electronic device housing. The first disassembly pins may be disposed on the base, and respectively corresponding to the flexible hooks and the first fasteners. The second disassembly pin may be disposed on the base, and corresponding to the fixation hook and the second fastener.

In a preferred embodiment, each of the first disassembly pins may include a pin base and a pin body, and the pin body may gradually taper from one end to the other end thereof.

In a preferred embodiment, each of the second disassembly pins may include a pin base and a pin body, and the pin body may gradually taper from one end to the other end thereof.

In a preferred embodiment, one end of each of the dowel pins may be fixed on the base, and the other end thereof may include a slope

The electronic device housing and the disassembly fixture thereof according to the present invention may have the following advantages:
(1) According to one embodiment of the present invention, the front cover of the electronic device housing may include at least one fastener hook capable of being caught on the second fastener of the back cover of the electronic device housing, which can provide higher interlocking force to compensate for the insufficient interlocking force provided by the flexible hooks and the first fasteners; therefore, the front cover and the back cover of the electronic device housing can be firmly combined with each other without screws; in this way, a repair technician can more efficiently disassemble the electronic device housing.
(2) According to one embodiment of the present invention, the front cover of the electronic device housing may include at least one flexible hook with a flexible member, and the flexible member can push and lift the front cover at the moment of the flexible hook separating from the first fastener; therefore, the repair technician can lightly press the front cover by single hand to remove the front cover instead of both hands; accordingly, the front cover will not be damaged.
(3) According to one embodiment of the present invention, the dissemble fixture may further include a plurality of dowel pins, so the repair technician can directly put the electronic device housing between the dowel pins to precisely insert the dowel pins of the disassembly fixture into the holes of the back cover of the electronic device housing, which is more convenient in use.

Further scope of applicability of the present application will become more apparent from the detailed description given hereinafter. However, it should be understood that the detailed description and specific examples, while indicating exemplary embodiments of the disclosure, are given by way of illustration only, since various changes and modifications within the scope of the disclosure will become apparent to those skilled in the art from this detailed description.

### BRIEF DESCRIPTION OF THE DRAWINGS

The present invention will become more fully understood from the detailed description given herein below and the accompanying drawings which are given by way of illustration only, and thus are not limitative of the present invention and wherein:
FIG. 1 is a first schematic view of a first embodiment of an electronic device housing in accordance with the present invention.
FIG. 2 is a second schematic view of the first embodiment of the electronic device housing in accordance with the present invention.
FIG. 3 is a third schematic view of the first embodiment of the electronic device housing in accordance with the present invention.
FIG. 4 is a fourth schematic view of the first embodiment of the electronic device housing in accordance with the present invention.
FIG. 5 is a fifth schematic view of the first embodiment of the electronic device housing in accordance with the present invention.
FIG. 6 is a sixth schematic view of the first embodiment of the electronic device housing in accordance with the present invention.
FIG. 7 is a first schematic view of a first embodiment of a disassembly fixture in accordance with the present invention.
FIG. 8 is a second schematic view of the first embodiment of the disassembly fixture in accordance with the present invention.
FIG. 9 is a third schematic view of the first embodiment of the disassembly fixture in accordance with the present invention.
FIG. 10 is a fourth schematic view of the first embodiment of the disassembly fixture in accordance with the present invention.
FIG. 11 is a fifth schematic view of the first embodiment of the disassembly fixture in accordance with the present invention.
FIG. 12 is a schematic view of a second embodiment of a disassembly fixture in accordance with the present invention.
FIG. 13 is a schematic view of a third embodiment of a disassembly fixture in accordance with the present invention.
FIG. 14 is a schematic view of a fourth embodiment of a disassembly fixture in accordance with the present invention.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

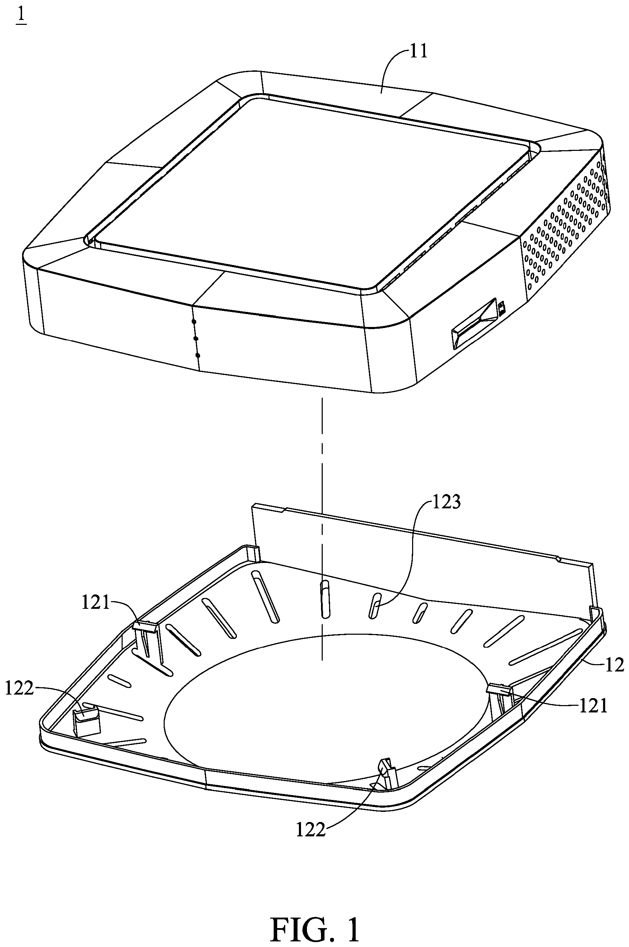

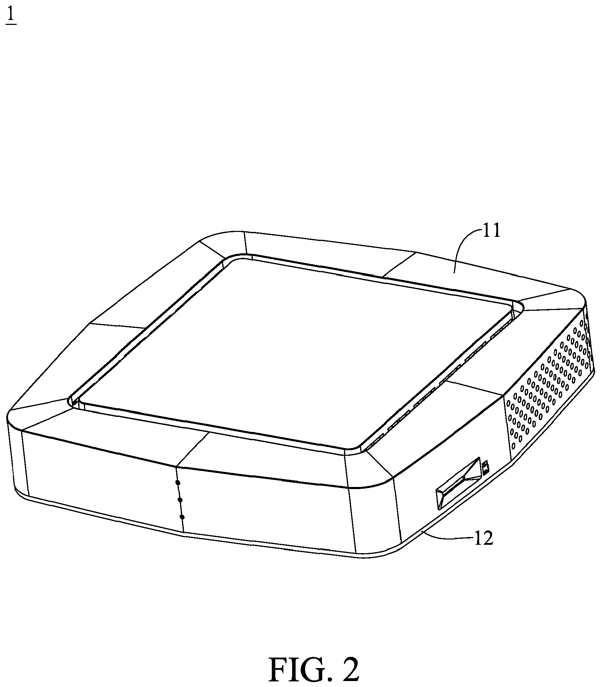

With reference to FIG. 1 and FIG. 2 for a first and a second schematic views of a first embodiment of an electronic device housing in accordance with the present invention, FIG. 1 and FIG. 2 illustrate a preferred structure of the electronic device housing in accordance with the present invention.

As shown in FIG. 1, the electronic device hosing 1 may include a front cover 11 and a back cover 12. The front cover 11 may include a plurality of hooks, and the back cover 12 may include a plurality of fasteners respectively corresponding to the hooks.

As shown in FIG. 2, the front cover 11 and the back cover 12 can be firmly fixed with each other after the hooks are caught on the fasteners.

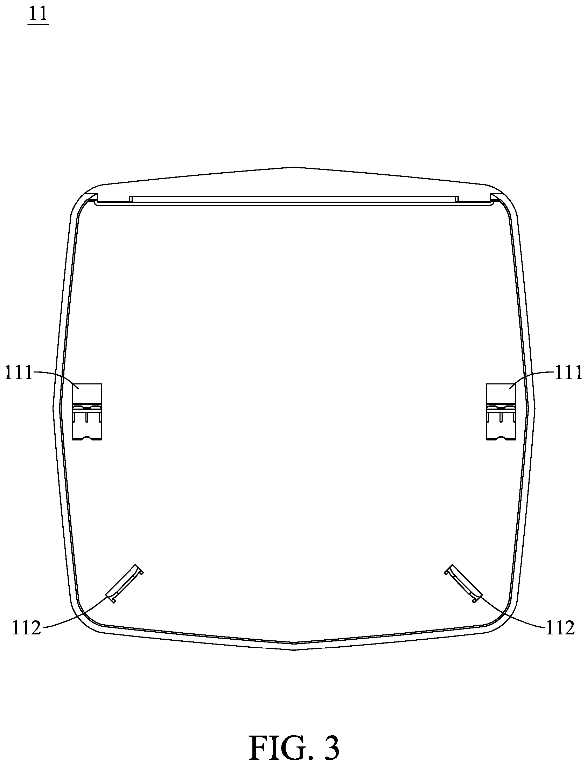

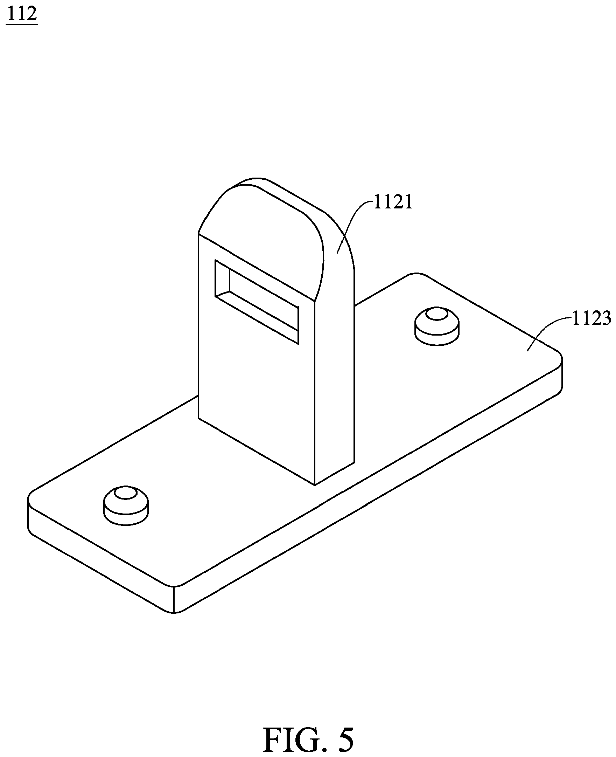

With reference to FIG. 3, FIG. 4 and FIG. 5 for a third, a fourth and a fifth schematic views of the first embodiment of the electronic device housing in accordance with the present invention, FIG. 3∼ FIG. 5 illustrate a preferred structure of the front cover of the electronic device housing in accordance with the present invention.

As shown in FIG. 3, the hooks of the front cover 11 of the electronic device housing 1 may include flexible hooks 111 and fixation hooks 112. The flexible hooks 111 and the fixation hooks 112 may be symmetrically distributed.

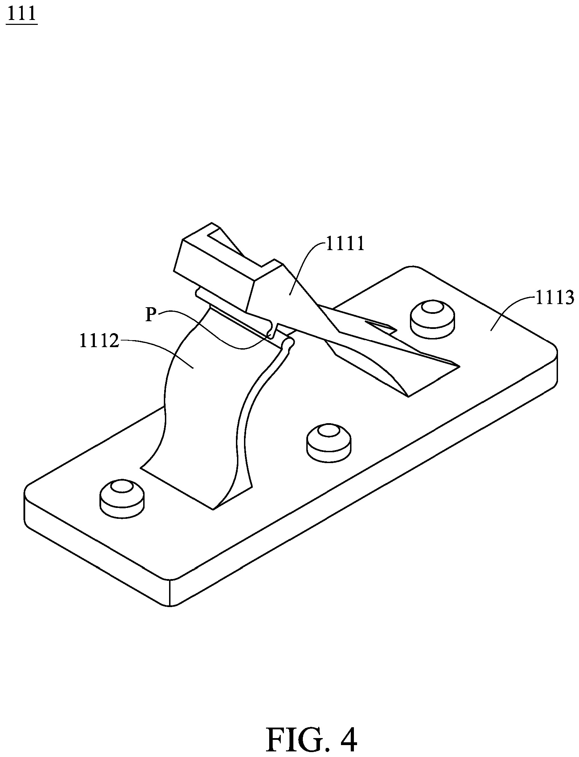

As shown in FIG. 4, each of the flexible hooks 111 may include a hook body, a flexible member and a hook base 1113. One end of the hook body 1111 may be fixed on the hook base 1113, and the hook body 1111 may gradually taper and then gradually widen from one end to the other end thereof; one side of the hook body 1111 may include a protrusion P. In the embodiment, the flexible member may be an elastic arm 1112, and one end of the elastic arm 1112 may be fixed on the hook base 1113, and the other end of the elastic arm 1112 may press against the protrusion P on one side of the hook body 1111 so as to provide support force to one side of the hook body 1111; in another preferred embodiment, the flexible member may be a spring and the like.

In the embodiment, the flexible hooks 111 may be symmetrically distributed, and disposed on two sides of the front cover 11 because the central area of the electronic device housing 1 may be used to contain the main circuit board or other electronic components. However, if the central area of the electronic device housing 1 has additional space for containing the flexible hook 111, the front cover 11 can have only one flexible hook 11 disposed at the center thereof; similarly, the front cover 11 can have only one fixation hook 12 disposed at the center of any one of the lateral sides thereof.

As shown in FIG. 5, each of the fixation hooks 112 may include a hook body 1121 and a hook base 1123; one end of the hook body 1121 may be fixed on the hook body 1123, and the other end of the hook body 1121 may include a slope.

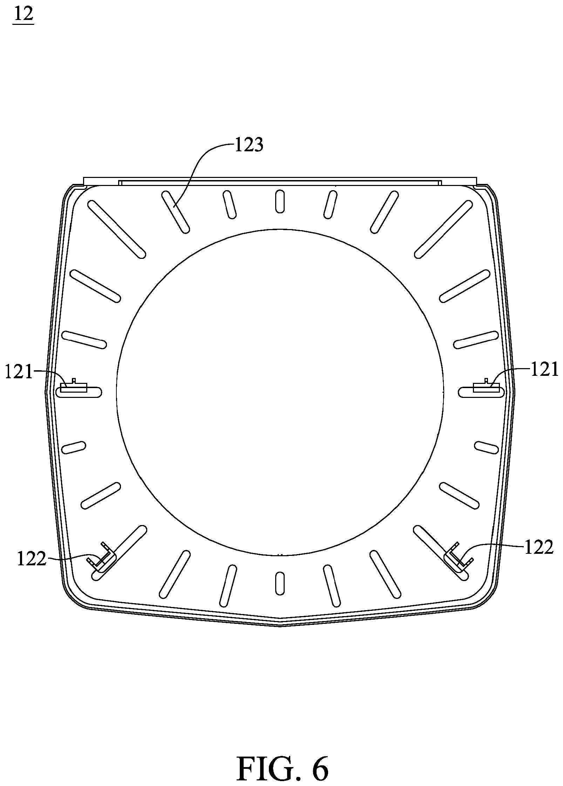

With reference to FIG. 6 for a sixth schematic view of a first embodiment of an electronic device housing in accordance with the present invention, FIG. 6 illustrates a preferred structure of the back cover of the electronic device housing in accordance with the present invention.

As shown in FIG. 6, the back cover 12 may include a plurality of first fasteners 121, a plurality of second fasteners 122 and a plurality of ventilation holes 123. The first fasteners 121 may be respectively corresponding to the flexible hooks 111, and caught on the flexible hooks 111; each of the first fasteners 121 may be disposed in the vicinity of one ventilation hole 123 and may partially overlap the ventilation hole 123. The second fasteners 122 may be respectively corresponding to the fixation hooks 112 and caught on the fixation hook 112; similarly, each of the second fasteners 122 may be disposed in the vicinity of one ventilation hole 123 and may partially overlap the ventilation hole 123.

In another preferred embodiment, the back cover 12 may have only one second fastener 122, and the second fastener 122 may be disposed at the center of any one of the lateral sides of the back cover 12 and corresponding to the fixation hook 112 of the front cover 11.

As described above, the front cove 11 of the electronic device housing 1 may include the fixation hooks 112 capable of being caught on the second fasteners 122 of the back cover 12, which can provide higher interlocking force to compensate for the insufficient interlocking force provided by the flexible hooks 111 and the first fasteners 121. In this way, the front cover 11 and the back cover 12 of the electronic device housing 1 can be firmly combined with each other without screws.

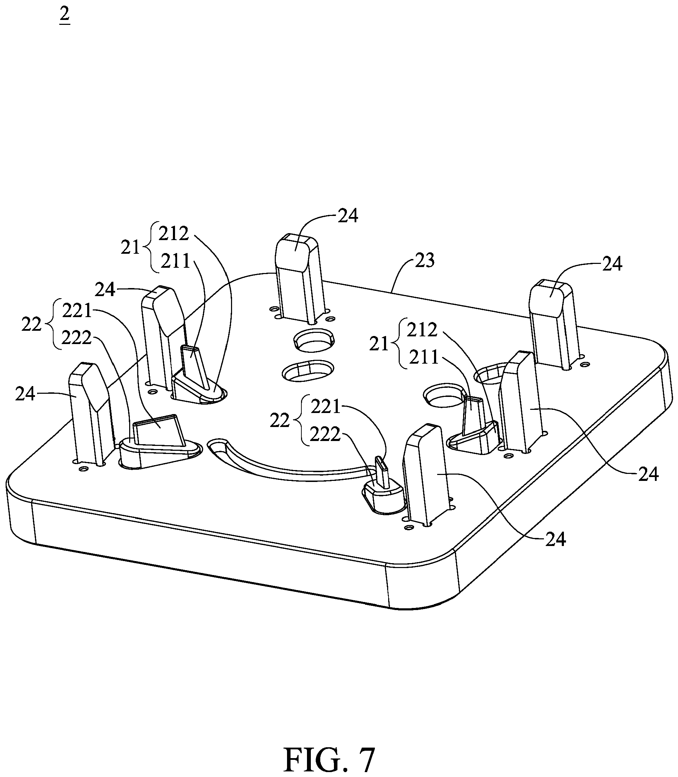

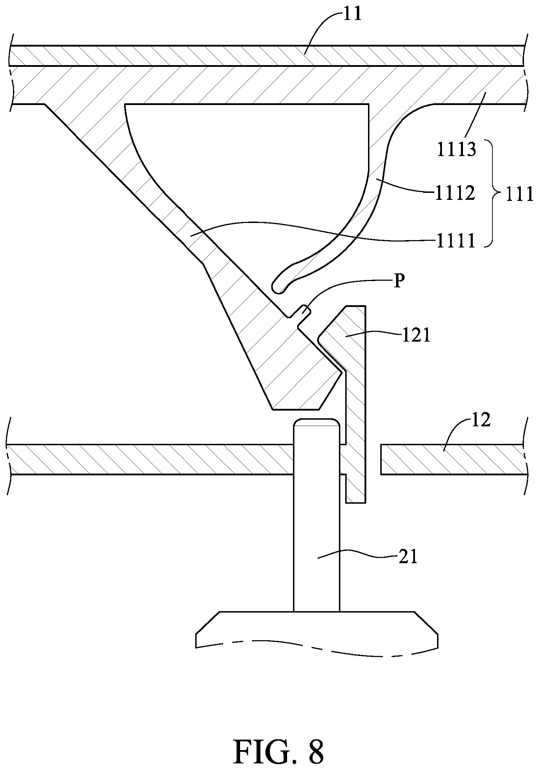

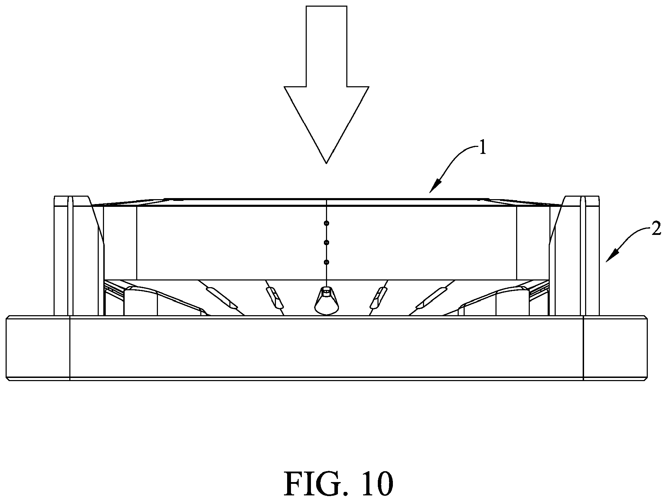

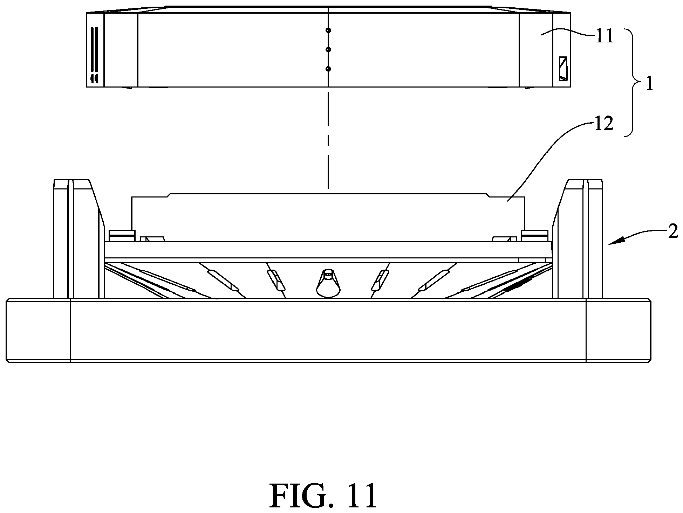

With reference to FIG. 7, FIG. 8, FIG, 9, FIG. 10 and FIG. 11 for a first, a second, a third, a fourth and a fifth schematic views of a first embodiment of a disassembly fixture in accordance with the present invention, FIG. 7-FIG. 11 illustrate a preferred structure of the disassembly fixture in accordance with the present invention for disassembling the aforementioned electronic device housing 1.

As shown in FIG. 7, the disassembly fixture 2 may include a base 23, a plurality of first disassembly pins 21, a plurality of second disassembly pins 22 and a plurality of dowel pins 24.

The first disassembly pins 21 may be disposed on the base 23, and respectively corresponding to the flexible hooks 111 and the first fasteners 121; each of the first disassembly pins 21 may include a pin base 121 and a pin body 211, and the pin body 211 may gradually taper from one end to the other end thereof.

The second disassembly pins 22 may be disposed on the base 23, and respectively corresponding to the fixation hooks 112 and the second fasteners 122; each of the second disassembly pins 22 may include a pin base 222 and a pin body 221, and the pin body 221 may gradually taper from one end to the other end thereof.

As shown in FIG. 8, when disassembling the electronic device housing 1, the use can put the electronic device housing 1 between the dowel pins 24 of the disassembly fixture 2, such that each of the first disassembly pins 21 may penetrate through one ventilation hole 23 to press against the hook body 1111 of one flexible hook 111 of the front cover 11; then, the hook body 1111 can separate from the first fastener 121 of the back cover 12. Meanwhile, the protrusion P of the hook body 1111 may press against the elastic arm 1112, such that the elastic arm 1112 may push and lift the front cover 11 at the moment of the hook body 1111 separating from the first fastener 121.

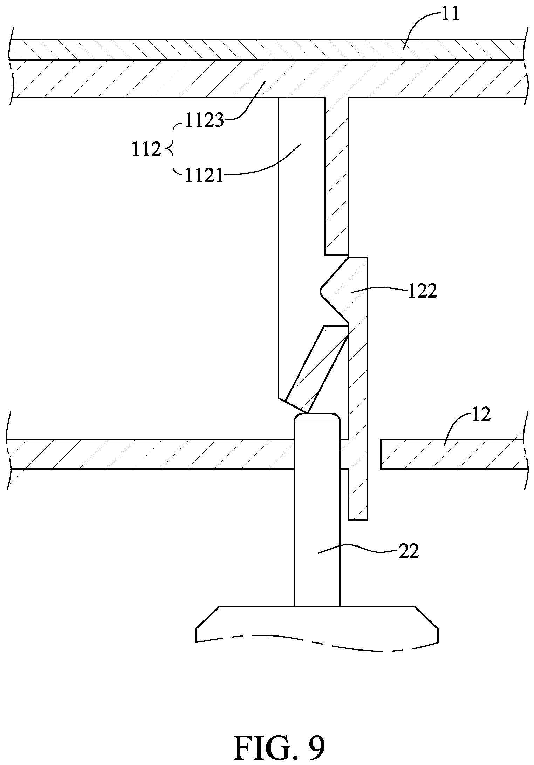

As shown in FIG. 9, each of the second disassembly pins 21 may penetrate through one ventilation hole 23 to press against the hook body 1121 of one fixation hook 112 of the front cover 11; then, the hook body 1121 can separate from the second fastener 122 of the back cover 12.

As shown in FIG. 10, when disassembling the electronic device housing 1, the use can put the electronic device housing 1 between the dowel pins 24 of the disassembly fixture 2, and then lightly press the front cover 11 toward the direction of the arrow shown in FIG. 10.

As shown in FIG. 11, the front cover 11 of the electronic device housing 1 can be pushed and lifted by the flexible hooks 111, but the back cover 12 can stay on the disassembly fixture 2, such that the user can easily and efficiently disassemble the electronic device housing 1.

It is worthy to point out that a conventional electronic device housing is usually fixed by several screws, so a repair technician should loosen and remove these screws before disassembling the electronic device housing; therefore, if the repair technician needs to deal with a lot of electronic devices, the repair technician should loosen and remove the screws of all of these electronic devices one by one, which is extremely inefficient. On the contrary, according to one embodiment of the present invention, the front cover of the electronic device housing may include at least one fastener hook capable of being caught on the second fastener of the back cover of the electronic device housing, which can provide higher interlocking force to compensate for the insufficient interlocking force provided by the flexible hooks and the first fasteners; therefore, the front cover and the back cover of the electronic device housing can be firmly combined with each other without screws; in this way, a repair technician can more efficiently disassemble the electronic device housing.

Besides, the repair technician should further align the performed holes of the back cover with a specially-designed fixture so as to insert the fixture into the performed holes to fix the back cover, and the use both of his hands to remove the front cover, which is very inconvenient in use; moreover, the front cover tends to be scraped or broken. On the contrary, according to one embodiment of the present invention, the dissemble fixture may further include a plurality of dowel pins, so the repair technician can directly put the electronic device housing between the dowel pins to precisely insert the disassembly pins of the disassembly fixture into the holes of the back cover of the electronic device housing, which is more convenient in use; in addition, the front cover of the electronic device housing may include at least one flexible hook with a flexible member, and the flexible member can push and lift the front cover at the moment of the flexible hook separating from the first fastener; therefore, the repair technician can lightly press the front cover by single hand to remove the front cover instead of both hands; accordingly, the front cover will not be damaged.

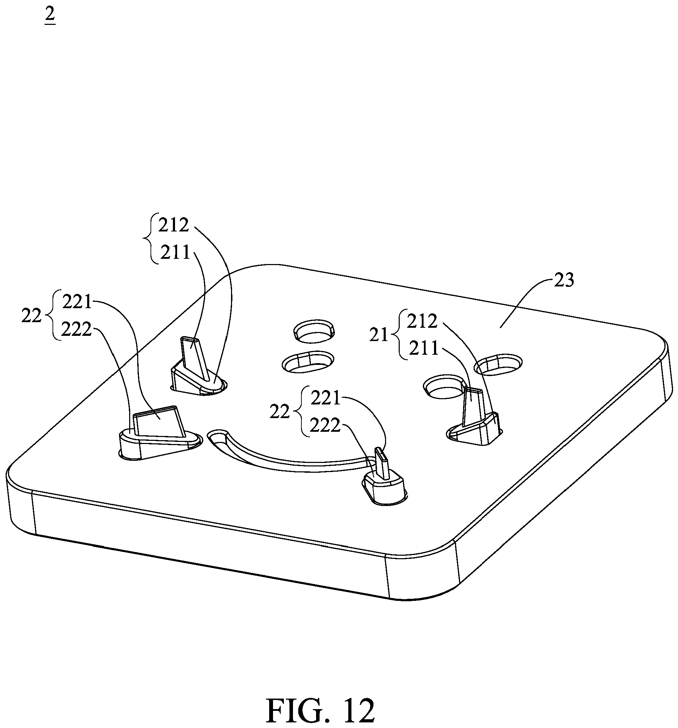

With reference to FIG. 12 for a schematic view of a second embodiment of a disassembly fixture in accordance with the present invention, FIG. 12 illustrate another preferred structure of the disassembly fixture in accordance with the present invention.

As shown in FIG. 12, the disassembly fixture 2 may include a base 23, a plurality of first disassembly pins 21 and a plurality of second disassembly pins 22. The difference between the embodiment and the previous embodiment is that the disassembly fixture 2 of the embodiment has no dowel pins.

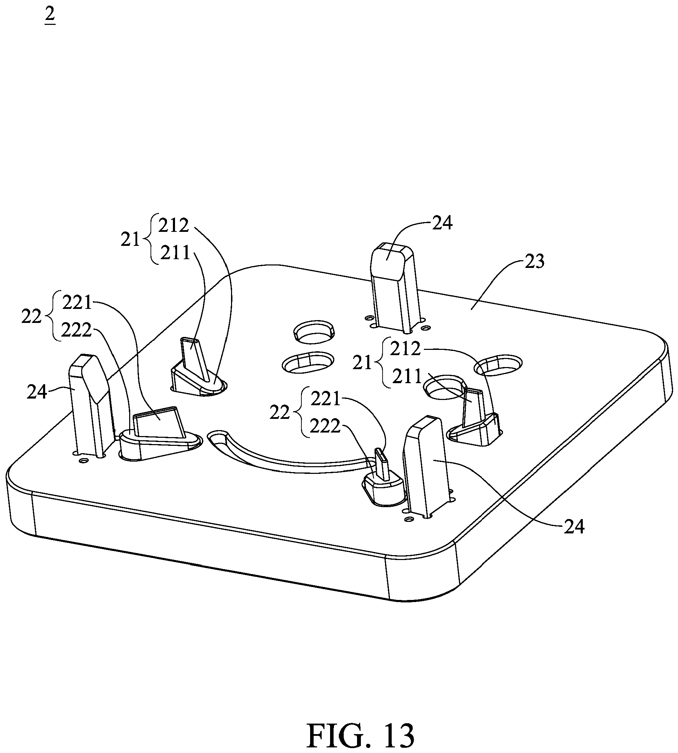

With reference to FIG. 13 for a schematic view of a third embodiment of a disassembly fixture in accordance with the present invention, FIG. 13 illustrate a further preferred structure of the disassembly fixture in accordance with the present invention.

As shown in FIG. 13, the disassembly fixture 2 may include a base 23, a plurality of first disassembly pins 21, a plurality of second disassembly pins 22 and a plurality of dowel pins 24. The difference between the embodiment and the previous embodiment is that the disassembly fixture 2 of the embodiment has only 3 dowel pins, and the dowel pins 24 may be distributed according to the shape of the electronic device housing 1 so as to fix the electronic device housing 1. Similarly, one end of each of the dowel pins 24 may be fixed on the base 23 and the other end thereof may include a slope.

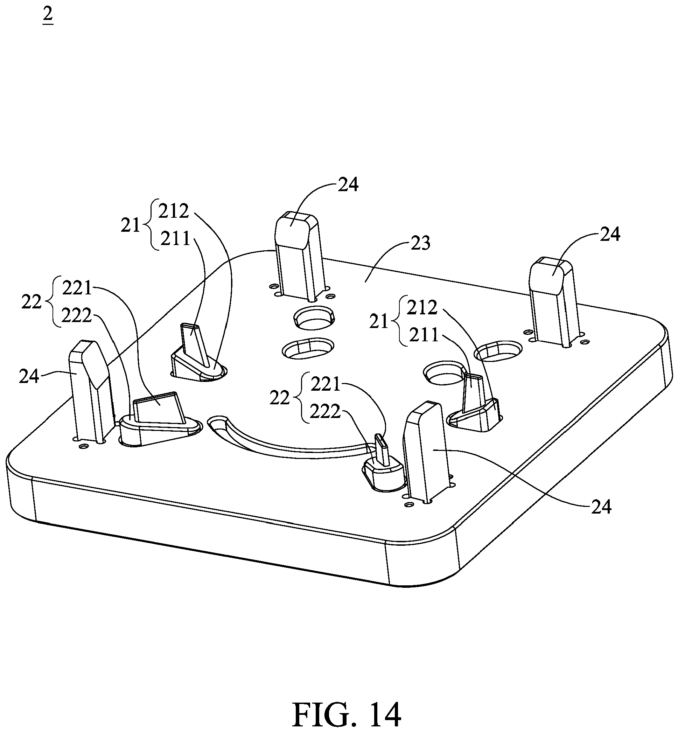

With reference to FIG. 14 for a schematic view of a fourth embodiment of a disassembly fixture in accordance with the present invention, FIG. 14 illustrate a still further preferred structure of the disassembly fixture in accordance with the present invention.

As shown in FIG. 14, the disassembly fixture 2 may include a base 23, a plurality of first disassembly pins 21, a plurality of second disassembly pins 22 and a plurality of dowel pins 24. The difference between the embodiment and the previous embodiment is that the disassembly fixture 2 of the embodiment has only 4 dowel pins, and the dowel pins 24 may be distributed according to the shape of the electronic device housing 1 so as to fix the electronic device housing 1. Similarly, one end of each of the dowel pins 24 may be fixed on the base 23 and the other end thereof may include a slope.

To sum up, according to one embodiment of the present invention, the front cover of the electronic device housing may include at least one fastener hook capable of being caught on the second fastener of the back cover of the electronic device housing, which can provide higher interlocking force to compensate for the insufficient interlocking force provided by the flexible hooks and the first fasteners; therefore, the front cover and the back cover of the electronic device housing can be firmly combined with each other without screws; in this way, a repair technician can more efficiently disassemble the electronic device housing.

Besides, according to one embodiment of the present invention, the front cover of the electronic device housing may include at least one flexible hook with a flexible member, and the flexible member can push and lift the front cover at the moment of the flexible hook separating from the first fastener; therefore, the repair technician can lightly press the front cover by single hand to remove the front cover instead of both hands; accordingly, the front cover will not be damaged.

Further, according to one embodiment of the present invention, the dissemble fixture may further include a plurality of dowel pins, so the repair technician can directly put the electronic device housing between the dowel pins to precisely insert the dowel pins of the disassembly fixture into the holes of the back cover of the electronic device housing, which is more convenient in use.

## Claims

1. An electronic device housing (1), comprising:
a front cover (11), comprising at least two flexible hooks (111) and at least one fixation hook (112), wherein each of the flexible hooks (111) comprises a first hook body (1111) and a flexible member; one end of the flexible member connects to the front cover (11) and the other end of the flexible member provides a support force to one side of the first hook body (1111); the fixation hook (112) comprises a second hook body (1121); and
a back cover (12), comprising at least two first fasteners (121), at least one second fastener (122) and at least three holes, wherein the holes are respectively corresponding to the first fasteners (121) and the second fastener (122); the first fasteners (121) are respectively corresponding to the flexible hooks (111) and caught on the flexible hooks (111); the second fastener (122) is corresponding to the fixation hook (111) and caught on the fixation hook (111), whereby the front cover (11) is able to be combined with the back cover (12), and the flexible member pushes and lifts the front cover (11) by the support force at the moment of the flexible hooks (111) separating from the first fastener (121).

2. The electronic device housing (1) of claim 1, **characterized in that** the flexible hooks (111) are symmetrically distributed.

3. The electronic device housing (1) of claim 1, **characterized in that** one end of the first hook body (1111) is fixed at the front cover (11), and the first fastener (121) is caught on the other end of the first hook body (1111); the first hook body (1111) gradually tapers and then gradually widens from one end to the other end thereof.

4. The electronic device housing (1) of claim 1, **characterized in that** the flexible member is a spring; one end of the spring is fixed at the front cover (11) and the other end of the spring is fixed at one side of the first hook body (1111).

5. The electronic device housing (1) of claim 1, **characterized in that** the flexible member is an elastic arm (1112); one end of the elastic arm (1112) is fixed at the front cover (11), and the other end of the elastic arm (1112) presses against one side of the first hook body (1111).

6. The electronic device housing (1) of claim 1, **characterized in that** one end of the fixation hook (112) is fixed at the front cover (11), and the other end of the fixation hook (112) comprises a slope and is caught on the second fastener (1122).

7. The electronic device housing (1) of claim 1, **characterized in that** the holes are ventilation holes, and each of the holes partially overlaps the first fastener (121) or the second fastener (122) corresponding to the hole in a vertical direction.

8. The electronic device housing of claim 5, **characterized in that** the elastic arm (1112) is curved; one side of the first hook body (1111) comprises a protrusion (P), and the protrusion (P) presses against the other end of the elastic arm (1112).

9. A system comprising: the electronic device housing (1) of any of the claims 1-8; a disassembly fixture (2) for disassembling the electronic housing (1), **characterized in that** the disassembly fixture comprising:
a base (23);
at least two first disassembly pins (21), disposed on the base (232), and respectively corresponding to the flexible hooks (111) and the first fasteners (121); and
at least one second disassembly pin (22), disposed on the base (23), and corresponding to the fixation hook (112) and the second fastener (122).

10. The system of claim 9, **characterized in that** each of the first disassembly pins (21) comprises a pin base (212) and a pin body (211), and the pin body (211) gradually tapers from one end to the other end thereof.

11. The system of claim 9, **characterized in that** each of the second disassembly pins comprises a pin base (222) and a pin body (221), and the pin body (221) gradually tapers from one end to the other end thereof.

12. The system of claim 9, **characterized in that** the disassembly fixture (2) further comprises a plurality of dowel pins (24), and the dowel pins (24) are disposed on the base (23) so as to fix the electronic device housing (1); one end of each of the dowel pins (24) is fixed on the base (23), and the other end thereof comprises a slope.

13. The system of claim 9, **characterized in that** the disassembly fixture (2) further comprises: a plurality of dowel pins (24), disposed on the base so as to fix the electronic device housing (1).

14. The system of claim 13, **characterized in that** each of the first disassembly pins (21) comprises a pin base (212) and a pin body (211), and the pin body (211) gradually tapers from one end to the other end thereof; one end of each of the dowel pins (24) is fixed on the base (23), and the other end thereof comprises a slope.

15. The system of claim 13, **characterized in that** each of the second disassembly pins (22) comprises a pin base (222) and a pin body (221), and the pin body (221) gradually tapers from one end to the other end thereof; one end of each of the dowel pins (24) is fixed on the base (23), and the other end thereof comprises a slope.

## Patentansprüche

1. Gehäuse (1) für ein elektronisches Gerät, umfassend:
eine vordere Abdeckung (11), die mindestens zwei flexible Haken (111) und mindestens einen Befestigungshaken (112) umfasst, wobei jeder der flexiblen Haken (111) einen ersten Hakenkörper (1111) und ein flexibles Element umfasst; wobei ein Ende des flexiblen Elements mit der vorderen Abdeckung (11) verbunden ist und das andere Ende des flexiblen Elements eine Stützkraft auf eine Seite des ersten Hakenkörpers (1111) ausübt; wobei der Befestigungshaken (112) einen zweiten Hakenkörper (1121) umfasst; und
eine hintere Abdeckung (12), umfassend mindestens zwei erste Befestigungselemente (121), mindestens ein zweites Befestigungselement (122) und mindestens drei Löcher, wobei die Löcher jeweils den ersten Befestigungselementen (121) und dem zweiten Befestigungselement (122) entsprechen; wobei die ersten Befestigungselemente (121) jeweils den flexiblen Haken (111) entsprechen und an den flexiblen Haken (111) eingefangen werden; und das zweite Befestigungselement (122) dem Befestigungshaken (111) entspricht und an dem Befestigungshaken (111) eingefangen wird, wodurch die vordere Abdeckung (11) geeignet ist, mit der hinteren Abdeckung (12) kombiniert zu werden, und das flexible Element die vordere Abdeckung (11) im Moment der Trennung der flexiblen Haken (111) von dem ersten Befestigungselement (121) durch die Stützkraft schiebt und anhebt.

2. Gehäuse (1) für ein elektronisches Geräts nach Anspruch 1, **dadurch gekennzeichnet, dass** die flexiblen Haken (111) symmetrisch verteilt angeordnet sind.

3. Gehäuse (1) für ein elektronisches Gerät nach Anspruch 1, **dadurch gekennzeichnet, dass** ein Ende des ersten Hakenkörpers (1111) an der vorderen Abdeckung (11) befestigt ist, und das erste Befestigungselement (121) am anderen Ende des ersten Hakenkörpers (1111) eingefangen wird; wobei der erste Hakenkörper (1111) sich allmählich verjüngt und sich dann allmählich von einem Ende zum anderen Ende weitet.

4. Gehäuse (1) für ein elektronisches Gerät nach Anspruch 1, **dadurch gekennzeichnet, dass** das flexible Element eine Feder ist; wobei ein Ende der Feder an der vorderen Abdeckung (11) befestigt ist und das andere Ende der Feder an einer Seite des ersten Hakenkörpers (1111) befestigt ist.

5. Gehäuse (1) für ein elektronisches Gerät nach Anspruch 1, **dadurch gekennzeichnet, dass** das flexible Element ein elastischer Arm (1112) ist; wobei ein Ende des elastischen Arms (1112) an der vorderen Abdeckung (11) befestigt ist, und das andere Ende des elastischen Arms (1112) gegen eine Seite des ersten Hakenkörpers (1111) drückt.

6. Gehäuse (1) für ein elektronisches Gerät nach Anspruch 1, **dadurch gekennzeichnet, dass** ein Ende des Fixierungshakens (112) an der Frontabdeckung (11) befestigt ist, und das andere Ende des Befestigungshakens (112) eine Schräge umfasst und an dem zweiten Befestigungselement (122) eingefangen wird.

7. Gehäuse (1) für ein elektronisches Gerät nach Anspruch 1, **dadurch gekennzeichnet, dass** die Löcher Lüftungslöcher sind, und jedes der Löcher das erste Befestigungselement (121) oder das dem Loch entsprechende zweite Befestigungselement (122) in vertikaler Richtung teilweise überlappt.

8. Gehäuse für ein elektronisches Gerät nach Anspruch 5, **dadurch gekennzeichnet, dass** der elastische Arm (1112) gekrümmt ist; und eine Seite des ersten Hakenkörpers (1111) einen Vorsprung (P) umfasst und der Vorsprung (P) gegen das andere Ende des elastischen Arms (1112) drückt.

9. System umfassend: Gehäuse für ein elektronisches Gerät (1) nach einem der Ansprüche 1-8; eine Demontagevorrichtung (2) zur Demontage des Gehäuses für ein elektronisches Gerät (1),
**dadurch gekennzeichnet, dass** die Demontagevorrichtung umfasst:
eine Basis (23);
mindestens zwei erste Demontagestifte (21), die auf der Basis (23) angeordnet sind, und jeweils den flexiblen Haken (111) und den ersten Befestigungselementen (121) entsprechen; und
mindestens einen zweiten Demontagestift (22), der an der Basis (23) angeordnet ist, und dem Befestigungshaken (112) und dem zweiten Befestigungselement (122) entspricht.

10. System nach Anspruch 9, **dadurch gekennzeichnet, dass** jeder der ersten Demontagestifte (21) eine Stiftbasis (212) und einen Stiftkörper (211) umfasst, und der Stiftkörper (211) sich allmählich von einem Ende zum anderen Ende verjüngt.

11. System nach Anspruch 9, **dadurch gekennzeichnet, dass** jeder der zweiten Demontagestifte eine Stiftbasis (222) und einen Stiftkörper (221) umfasst, und der Stiftkörper (221) sich allmählich von einem Ende zum anderen Ende verjüngt.

12. System nach Anspruch 9, **dadurch gekennzeichnet, dass** die Demontagevorrichtung (2) ferner eine Vielzahl von Passstiften (24) umfasst, und die Passstifte (24) auf der Basis (23) angeordnet sind, um das Gehäuse (1) für ein elektronisches Gerät zu befestigen; wobei ein Ende jedes der Passstifte (24) auf der Basis (23) befestigt ist, und das andere Ende davon eine Schräge umfasst.

13. System nach Anspruch 9, **dadurch gekennzeichnet, dass** die Demontagevorrichtung (2) ferner umfasst:
eine Vielzahl von Passstiften (24), die auf der Basis angeordnet sind, um das Gehäuse (1) für ein elektronisches Gerät zu befestigen.

14. System nach Anspruch 13, **dadurch gekennzeichnet, dass** jeder der ersten Demontagestifte (21) eine Stiftbasis (212) und einen Stiftkörper (211) umfasst, und der Stiftkörper (211) sich von einem Ende zum anderen Ende allmählich verjüngt; wobei ein Ende jedes der Passstifte (24) an der Basis (23) befestigt ist, und das andere Ende davon eine Schräge umfasst.

15. System nach Anspruch 13, **dadurch gekennzeichnet, dass** jeder der zweiten Demontagestifte (22) eine Stiftbasis (222) und einen Stiftkörper (221) umfasst, und der Stiftkörper (221) sich von einem Ende zum anderen Ende allmählich verjüngt; wobei ein Ende jedes der Passstifte (24) an der Basis (23) befestigt ist, und das anderes Ende davon eine Schräge aufweist.

## Revendications

1. Boîtier de dispositif électronique (1) comprenant :
un capot avant (11) comprenant au moins deux crochets souples (111) et au moins un crochet de fixation (112), chacun des crochets souples (111) comprenant : un premier corps de crochet (1111) et un élément souple, une extrémité de l'élément souple se connectant au capot avant (11) et l'autre extrémité de l'élément souple exerçant une force de support sur une face du premier corps de crochet (1111), le crochet de fixation (112) comprenant un second corps de crochet (1121), et
un capot arrière (12) comprenant au moins deux premières attaches (121), au moins une seconde attache (122) et au moins trois trous, les trous correspondant respectivement aux premières attaches (121) et à la seconde attache (122) ; les premières attaches (121) correspondant respectivement aux crochets souples (111) et étant accrochées aux crochets souples (111) ; la seconde attache (122) correspondant au crochet de fixation (111) et étant accrochée au crochet de fixation (111), le capot avant (11) étant apte à être combiné avec le capot arrière (12), et l'élément souple poussant et soulevant le capot avant (11) par la force de support au moment où les crochets souples (111) se séparent de la première attache (121).

2. Boîtier de dispositif électronique (1) selon la revendication 1, **caractérisé en ce que** les crochets souples (111) sont répartis symétriquement.

3. Boîtier de dispositif électronique (1) selon la revendication 1, **caractérisé en ce qu'**une extrémité du premier corps de crochet (1111) est fixée au capot avant (11), et que la première attache (121) est accrochée à l'autre extrémité du premier corps de crochet (1111) ; que le premier corps de crochet (1111) se rétrécit graduellement puis s'élargit graduellement depuis l'une de ses extrémités jusqu'à l'autre.

4. Boîtier de dispositif électronique (1) selon la revendication 1, **caractérisé en ce que** l'élément souple est un ressort ; qu'une extrémité du ressort est fixée au capot avant (11) et que l'autre extrémité du ressort est fixée à une face du premier corps de crochet (1111).

5. Boîtier de dispositif électronique (1) selon la revendication 1, **caractérisé en ce que** l'élément souple est un bras élastique (1112) ; qu'une extrémité du bras élastique (1112) est fixée au capot avant (11), et que l'autre extrémité du bras élastique (1112) appuie contre une face du premier corps de crochet (1111).

6. Boîtier de dispositif électronique (1) selon la revendication 1, **caractérisé en ce qu'**une extrémité du crochet de fixation (112) est fixée au capot avant (11), et que l'autre extrémité du crochet de fixation (112) comprend une pente et est accrochée à la seconde attache (1122).

7. Boîtier de dispositif électronique (1) selon la revendication 1, **caractérisé en ce que** les trous sont des trous de ventilation, et que chacun des trous recouvre partiellement la première attache (121) ou la seconde attache (122) correspondant au trou dans un sens vertical.

8. Boîtier de dispositif électronique (1) selon la revendication 5, **caractérisé en ce que** le bras élastique (1112) est recourbé ; qu'une face du premier corps de crochet (1111) comprend une saillie (P) et que la saillie (P) appuie contre l'autre extrémité du bras élastique (1112).

9. Système comprenant : le boîtier de dispositif électronique (1) selon l'une quelconque des revendications 1 à 8 ; un système de démontage (2) pour démonter le boîtier électronique (1),
**caractérisé en ce que** le système de démontage comprend :
une base (23) ;
au moins deux premières broches de démontage (21) disposées sur la base (23), et correspondant respectivement aux crochets flexibles (111) et aux premières attaches (121) ; et
au moins une seconde broche de démontage (22) disposée sur la base (23), et correspondant au premier crochet de fixation (112) et à la seconde attache (122).

10. Système selon la revendication 9, **caractérisé en ce que** chacune des premières broches de démontage (21) comprend une base de broche (212) et un corps de broche (211), et que le corps de broche (211) se rétrécit graduellement depuis sa première extrémité jusqu'à son autre extrémité.

11. Système selon la revendication 9, **caractérisé en ce que** chacune des secondes broches de démontage comprend une base de broche (222) et un corps de broche (221), et que le corps de broche (221) se rétrécit graduellement depuis sa première extrémité jusqu'à son autre extrémité.

12. Système selon la revendication 9, **caractérisé en ce que** le système de démontage (2) comprend en outre une pluralité de goupilles (24), et que les goupilles (24) sont disposées sur la base (23) de manière à fixer le boîtier de dispositif électronique (1) ; qu'une extrémité de chacune des goupilles (24) est fixée sur la base (23), et que son autre extrémité comprend une pente.

13. Système selon la revendication 9, **caractérisé en ce que** le système de démontage (2) comprend en outre :
une pluralité de goupilles (24) disposées sur la base de manière à fixer le boîtier de dispositif électronique (1).

14. Système selon la revendication 13, **caractérisé en ce que** chacune des premières broches de démontage (21) comprend une base de broche (212) et un corps de broche (211), et que le corps de broche (211) se rétrécit graduellement depuis l'une de ses extrémités jusqu'à l'autre ; que chacune des goupilles (24) est fixée sur la base (23), et que son autre extrémité comprend une pente.

15. Système selon la revendication 13, **caractérisé en ce que** chacune des secondes broches de démontage (22) comprend une base de broche (222) et un corps de broche (221), et que le corps de broche (221) se rétrécit graduellement depuis l'une de ses extrémités jusqu'à l'autre ; qu'une extrémité de chacune des goupilles de début (24) est fixée à l'début sur la base (23), et que son autre extrémité comprend une pente.
